# EUROPÄISCHE PATENTSCHRIFT

(11) **EP 0 752 199 B1**
(45) Veröffentlichungstag und Bekanntmachung des Hinweises auf die Patenterteilung: **15.10.1997**
(21) Anmeldenummer: 95910437.3
(22) Anmeldetag: 02.03.1995
(51) Int. Cl.: H05K 7/14

(54) **TRÄGERPLATTE FÜR BAUGRUPPEN**
SUBRACK
PLAQUE D'ASSEMBLAGE POUR BAIE DE MONTAGE

(30) Priorität: 14.03.1994 DE 4408542
(43) Veröffentlichungstag der Anmeldung: 08.01.1997
(73) Patentinhaber: Siemens Nixdorf Informationssysteme AG, 33106 Paderborn (DE)
(72) Erfinder: KNOOP, Franz-Josef, D-33142 Büren (DE)
(74) Vertreter: Fuchs, Franz-Josef, Dr.-Ing.
(86) Internationale Anmeldenummer: DE9500279
(87) Internationale Veröffentlichungsnummer: WO9525421

(56) Entgegenhaltungen:
- EP-A- 0 299 199
- EP-A- 0 317 464
- EP-A- 0 474 181
- CH-A- 653 837
- DE-A- 4 104 984
- DE-B- 1 231 772

## Beschreibung

### Technisches Gebiet

Die Anordnung betrifft die Montage von Baugruppen auf einer gemeinsamen Rückwand.

### Stand der Technik

Für die Verbindung von steckbaren Baugruppen sind Rückwände in gedruckter Schaltungstechnik üblich. Diese werden vorzugsweise für elektronische Flachbaugruppen eingesetzt, die in größerer Anzahl parallel zueinander gesteckt sind.

Für Peripheriegeräte wie Magnetplattenspeicher sind hingegen Flachkabelverbinder üblich, wobei die Geräte an ihren Längsseiten befestigt und über die Flachkabelverbinder an ihrer Rückseite kontaktiert sind.

Insbesondere mit der preiswerten Verfügbarkeit volumenmäßig kleiner Magnetplattenlaufwerke in 3½" oder 2½" Technik in Zusammenhang mit Plattenbussystemen wie SCSI sowie der RAID-Technik sind eine große Anzahl kleiner Laufwerke zu befestigen und zu verdrahten.

Aufgabe der Erfindung ist es, einen Baugruppenträger anzugeben, in den Moduln verschiedener Höhe in beliebig vorbestimmbarer Reihenfolge steckbar angeordnet werden können, ohne daß der Baugruppenträger selbst angepaßt werden muß. Dabei soll eine gute Abdichtung gegen Störstrahlung möglich sein.

### Darstellung der Erfindung

Diese Aufgabe wird dadurch gelöst, daß für im folgenden als Moduln bezeichnete Baugruppen, die nicht die volle Bauhöhe, sondern insbesondere nur die halbe, ein Drittel oder Viertel der vollen Bauhöhe aufweisen (teilhohe Moduln), eine Trägerplatte ähnlich einem sehr schmalen Modul voller Bauhöhe verwendet wird, die die Führungsschienen in dem Baugruppenträger für Moduln voller Bauhöhe verwendet und auf ihrer Fläche ihrerseits Führungsschienen für die zu tragenden Moduln aufweist. Die Moduln an der Trägerplatte sind übereinander angeordnet und daher meist mit gleich breiter Frontblende ausgeführt.

Damit ist es möglich, die Abfolge von Plätzen für teilhohe Moduln und Moduln von voller Bauhöhe beliebig vorherzubestimmen. Dies ist von besonderer Bedeutung bei Hochleistungs-Mehrbenutzerrechnern mit großem Massenspeichervolumen, welches zweckäßig und kostengünstig aus Festplattenlaufwerken im 3½" oder 2½" Format aufgebaut wird, die für Personal Computer in hohen Stückzahlen produziert werden. Der Baugruppenträger kann dabei einerseits die Zentraleinheit und den Arbeitsspeicher als Flachbaugruppen voller Bauhöhe aufnehmen. Die Steuergeräte für die Festplatten sind gleichfalls als Flachbaugruppen meist voller Höhe ausgeführt. Unmittelbar daneben sind auf einer oder zwei Trägerplatten zwei, drei, vier, sechs oder acht Plätze für Festplattenlaufwerke als teilhohe Moduln angeordnet und über die Rückwand ohne Kabel mit der jeweiligen Steuereinheit verbunden. Es ist dabei zu beachten, daß der dabei häufig verwendete SCSI-Bus maximal sieben Laufwerke zuläßt und daher für große Plattenkapazitäten mehrerer Steuereinheiten unabdingbar sind, die jedoch möglichst nahe an den Laufwerken angeordnet seien sollen. Durch die Führungsschienen sind die Laufwerke leicht nachrüstbar oder, insbesondere bei RAID-Systemen, im laufenden Betrieb auswechselbar. Ein weiterer Vorteil dieser Anordnung liegt in dem kompakten Aufbau und bei der der Verwendung von Magnetplattenlaufwerken dem Wegfall des bislang notwendigen, fehleranfälligen Anschlusses über Kabel.

Gleichfalls ist auch eine gute Störstrahlungs-Abschirmung mit einfachen Mitteln erreichbar, da die metallische Trägerplatte als Abschirmung dient und durch den kompakten Aufbau nur wenige, gut durch Schlitzfedern schließbare Spalte enstehen.

Wird die Trägerplatte durch eine Frontblende geringfügig verbreitert, so dient sie gleichzeitig als Lüftungskanal, der zweckmäßig ist, wenn die Moduln selbst kaum senkrechte Luftbewegung zulassen. Hierzu ist die Trägerplatte mit einer durchbrochenen Sicke versehen, die gleichzeitig ein senkrechter Luftkanal ist und durch die Durchbrüche einen Luftaustausch erlaubt.

Auch kann eine Trägerplatte verwendet werden, um Steuereinheiten anzuschließen, die für eine ganze Flachbaugruppe zu klein sind, aber dennoch leicht konfigurierbar sein sollen, beispielsweise für Datenübertragung für lokale und für Weitverkehrsnetze, die jeweils unterschiedliche Moduln erfordern.

Die im Ausführungsbeispiel dargestellte Form mit senkrecht angeordneten Moduln wird häufig aus Gründen der leichteren Kühlung der Moduln durch Konvektion vorgezogen. Dem steht jedoch eine um 90 Grad gedrehte horizontale Anordnung nicht entgegen, die zu verwenden ist, wenn entweder sehr viele Moduln unterzubringen sind und die Baubreite auf Kosten der Bauhöhe gering zu halten ist, oder ein Teil der Moduln für senkrechten Betrieb nicht zugelassen ist.

### Kurzbeschreibung der Zeichnungen

Es zeigen
- Fig. 1: eine Trägerplatte mit teilhohen Baugruppen vor einer Rückwand,
- Fig. 2: ein Detail der Führung auf der Trägerplatte,
- Fig. 3: eine alternative Ausführungsform für eine Führung auf der Trägerplatte,
- Fig. 4: ein Detail der Führung an den Rändern der Trägerplatte,
- Fig. 5: ein Detail betreffend Federbleche für Abschirmung
- Fig. 6: eine Trägerplatte mit angedeuteter durchbrochener Sicke

### Detaillierte Beschreibung der Erfindung

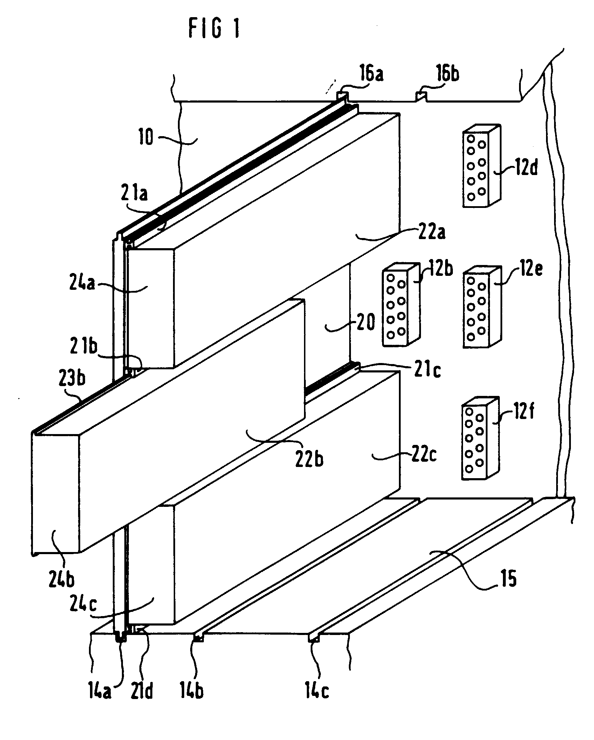

In Fig.1 ist eine Rückwand 10 dargestellt, die Teil eines Baugruppenträgers ist. Auf dieser Rückwand sind Steckverbinder 12a..f in einem rechtwinkligen Raster angeordnet, hier als Beispiel drei pro Spalte. Der Baugruppenträger hat eine nicht dargestelle Oberseite des Raums für die aufzunehmenden Moduln und eine Unterseite 15. In der Ober- und Unterseite sind Führungsschienen vorhanden, die hier als Nuten 14a..c, 16a..b dargestellt sind. Ein Modul bekannter Art mit voller Höhe, welche zugunsten der Übersichtlichkeit nicht dargestellt ist, trägt drei zu den Steckverbindern 12d..f passende Gegenstecker und wird, in den Nuten 14b und 16b gleitend, in den Baugruppenträger geschoben, bis die Steckverbinder eingerastet sind.

Als Beispiel für teilhohe Moduln sind Moduln 22a..c von im wesentlichen einem Drittel der vollen Höhe dargestellt. Sie werden von Führungsschienen 21a..d auf der Trägerplatte 20 geführt und rasten gleichfalls, hier jedoch mit je einem Steckverbinder, auf der Rückwand ein. Der oberste und unterste Modul 22a und 22c sind in eingesteckter Stellung gezeichnet, so daß die Steckverbinder 12a und 12c nicht sichtbar sind. Die Trägerplatte 20 ihrerseits wird von Nuten 14a auf der Unterseite 15 und einer entspechenden Nut in der Oberseite gehalten. Sie ist mit der Rückwand 10 mechanisch verbunden, beispielsweise verschraubt, und trägt damit zusätzlich zur Stabilität der Rückwand bei.

Die als Beispiel dargestellten teilhohen Moduln 22a..c sind auf einem Basisblech aufgebaut, dessen Kanten in den Führungsschienen auf der Trägerplatte gleiten. Auf dieses Blech sind quaderförmige Kästen aufgesetzt, deren Vorderseite als Blende dient. An der Rückseite ist das Gegenstück für den Steckverbinder auf der Rückwand angebracht. In den quaderförmigen Kästen sind beispielsweise Magnetplattenlaufwerke mit SCSI-Bus installiert.

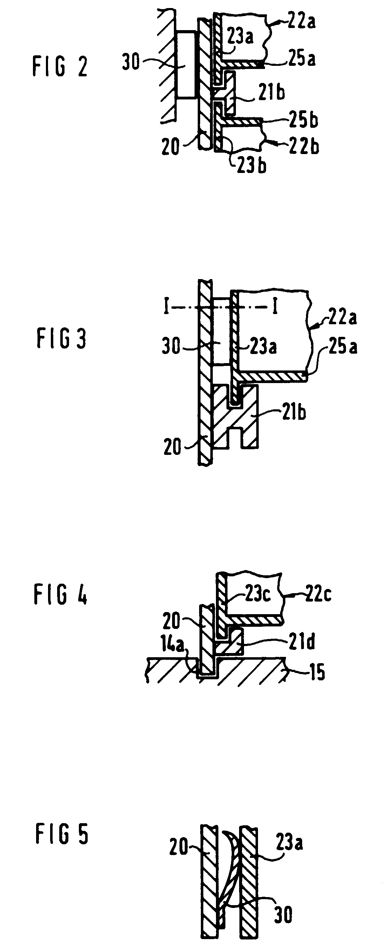

In Fig. 2 ist eine mögliche Ausführung der Führungsschiene 21b auf der Trägerplatte 20 dargestellt. Die Führungsschiene 21b ist als T-Schiene ausgeführt, so daß die Basisplatten 23a und 23b der Moduln 22a und 22b in der Nut zwischen T-Schiene 21b und Trägerplatte 20 gleiten. Die Moduln 22a und 22b haben eine Unterseite 25a und Oberseite 25b. Eine andere möglich Form mit H-förmigen Schienen ist in Fig. 3 gezeigt. Fig. 4 zeigt eine mögliche, zu Fig. 2 passende Ausführung der Führungsschiene 21d am unteren Ende mit der Führungsschiene 14a im Baugruppenträger für die Trägerplatte 20.

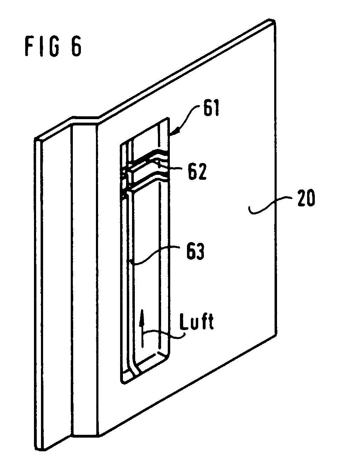

Zur Abdichtung gegen Störstrahlung dienen die Federleisten 30. In Fig. 2 ist die Abdichtung eines anderen Moduls gegenüber der Trägerplatte 20 dargestellt. Dabei werden die Federleisten meist länger als dargestellt ausgebildet, so daß sie praktisch den gesamten Schlitz verschließen. Bei der Ausführung nach Fig.3 sind zusätzliche Federleisten 30 vorgesehen, die den Spalt zwischen der Basisplatte 23a und der Trägerplatte 20 abdichten. Fig. 5 ist ein Blick von oben auf eine mögliche Ausführungsform einer Federleiste.

Fig. 6 zeigt eine Trägerplatte 20, die durch eine Frontblende gegenüber der durch die Blechdicke und die (nicht in Fig. 6 gezeigten) Führungsschienen vorgegebenen Breite verbreitert ist. Auf der Fläche der Trägerplatte 20 wird eine durchbrochene Sicke hergestellt. Der Übersichlichkeit halber sind nur einer von mehreren senkrechten Stegen 63 und zwei waagerechte Stege 62 gezeigt, die durch Ausstanzen von rechteckigen Löchern entstehen. Durch eine Verformung werden die Stege aus der Fläche heraus in Gegenrichtung zu der Seite, auf der die Führungsschienen angeordnet sind, verschoben. Damit entsteht ein senkrechter Luftkanal, der zur Kühlung der auf der Trägerplatte angebrachten Moduln dient.

In den Moduln 22a..c kann eine nicht dargestellte Zieh- und Verriegelungsmechanik bekannter Art eingesetzt werden, für die in der Trägerplatte 20 Widerlager vorgesehen sind. Durch die große Stabilität der Trägerplatte können diese stabil ausgeführt werden, so daß auch Zieh- und Steckkräfte für Steckverbinder mit großer Anzahl von Kontakten bereitgestellt werden können.

Die Moduln können mit Blenden an der Frontseite ausgestattet sein, wobei die seitlichen Kanten der Blenden durch senkrecht auf den Blenden stehende Flächen vergrößert und diese Flächen durch Kontaktfedern mit den jeweilig benachbarten Trägerplatten bzw. Moduln elektrisch verbunden sind.

## Patentansprüche

1. Anordnung, bestehend aus einem Baugruppenträger und steckbar angeordneten elektronischen Moduln unterschiedlicher Höhe, die durch eine gemeinsame Rückwand (10), die Teil des Baugruppenträgers ist, verbunden sind, mit den Merkmalen:
- Die Moduln stehen senkrecht auf der Rückwand,
- jeder Modul ist durch Steckverbinder (12a..f) mit der Rückwand (10) verbunden,
- endend an der Oberkante und der Unterkante der Rückwand sind im Baugruppenträger Führungselemente (14a, 16a) des Baugruppenträgers für Moduln voller Höhe vorhanden,
gekennnzeichnet durch:
- teilhohe Moduln (22a..c), deren Höhe nicht die ganze Höhe der Rückwand beträgt, werden von einer Trägerplatte (20) der vollen Höhe gehalten, wobei die Trägerplatte
- mit der Rückwand mechanisch verbunden ist,
- von den Führungselementen (14a, 16a) im Baugruppenträger gehalten wird,
- auf ihrer Fläche Führungsschienen (21a..d) senkrecht zur Rückwand besitzt, in denen die teilhohen Moduln (22a..c) gehalten werden.

2. Anordnung nach Anspruch 1, wobei die Führungsschienen (21a..d) Nuten enthalten, in die Führungsstege an der Ober- und Unterkante eines Moduls (22a..c) eingreifen.

3. Anordnung nach Anspruch 2, wobei die Moduln aus einer Basisplatte (23a,23b) bestehen, deren Kanten die Führungsstege bilden.

4. Anordnung nach Anspruch 3, wobei die Moduln an der der Rückwand entgegengesetzten Seite Blenden parallel zur Rückwand besitzen, die bei allen teilhohen Moduln auf derselben Trägerplatte gleich breit sind.

5. Anordnung nach Anspruch 4, wobei die Moduln ein auf die Basisplatte aufgesetztes quaderförmiges Gehäuse umfassen, dessen eine Fläche von der Basisplatte gebildet oder auf ihr aufgesetzt ist und dessen dazu parallele Fläche teilweise oder ganz entfallen kann und dessen Vorderseite (24a..c) die Blende ersetzt.

6. Anordnung nach Anspruch 4 oder 5, wobei die seitlichen Kanten der Blenden durch senkrecht auf den Blenden stehende Flächen vergrößert und diese Flächen durch Kontaktfedern mit den jeweilig benachbarten Trägerplatten bzw. Moduln elektrisch verbunden sind.

7. Anordnung nach einem der vorhergehenden Ansprüche, wobei die Trägerplatte eine oder mehrere durchbrochene Sicken aufweist, vorzugsweise in senkrechter Richtung.

8. Anordnung nach einem der vorhergehenden Ansprüche, wobei eine Verriegelungs- und Ziehmechanik der Moduln in ein Gegenlager auf den Trägerplatten greift.

## Claims

1. Arrangement, comprising a mounting rack and electronic modules of different height which are arranged such that they can be plugged in and are connected by means of a common rear wall (10) which is part of the mounting rack, having the features:
- the modules are positioned at right angles on the rear wall,
- each module is connected by plug connectors (12a..f) to the rear wall (10),
- there are guide elements (14a, 16a) of the mounting rack, in the mounting rack, ending at the top edge and at the bottom edge of the rear wall, for full-height modules,
characterized by:
- partial-height modules (22a..c), whose height is not the same as the entire height of the rear wall, being held by a full-height mounting panel (20), the mounting panel
- being mechanically connected to the rear wall,
- being held by the guide elements (14a, 16a) in the mounting rack,
- having guide rails (21a..d) at right angles to the rear wall on its surface, in which guide rails (21a..d) the partial-height modules (22a..c) are held.

2. Arrangement as claimed in Claim 1, the guide rails (21a..d) containing grooves in which guide webs on the upper and lower edges of a module (22a..c) engage.

3. Arrangement as claimed in Claim 2, the modules comprising a base plate (23a, 23b) whose edges form the guide webs.

4. Arrangement as claimed in Claim 3, the modules having panels parallel to the rear wall on the side opposite the rear wall, the width of which panels is the same for all partial-height modules on the same mounting panel.

5. Arrangement as claimed in Claim 4, the modules comprising a box-shaped housing which is placed onto the base plate and one of whose surfaces is formed by the base plate or is placed on it, and whose surface parallel thereto can be partially or entirely omitted, and whose front (24a..c) replaces the panel.

6. Arrangement as claimed in Claim 4 or 5, the side edges of the panels being enlarged by surfaces which are at right angles to the panels, and these surfaces being electrically connected by contact springs to the respectively adjacent mounting panels and/or modules.

7. Arrangement as claimed in one of the preceding claims, the mounting panel having one or more interrupted beads, preferably in the vertical direction.

8. Arrangement as claimed in one of the preceding claims, an interlocking and pulling mechanism of the modules engaging in an opposing bearing on the mounting panels.

## Revendications

1. Dispositif, constitué d'un porte-modules et de modules électroniques enfichables de hauteur diverse, qui sont reliés par un panneau (10) arrière commun, qui fait partie du porte-modules, comportant les dispositions:
- les modules sont perpendiculaires au panneau arrière,
- chaque module est relié par des connecteurs (12a...12f) au panneau (10) arrière,
- finissant au bord supérieur et au bord inférieur du panneau arrière, il est présent, dans le porte-modules, des éléments (14a, 16a) de guidage du porte-modules destinés à des modules de pleine hauteur,
caractérisé en ce que:
des modules (22a...22c) de hauteur partielle, dont la hauteur n'est pas égale à toute la hauteur du panneau arrière, sont maintenus par une plaque (20) de support de pleine hauteur, la plaque de support
- étant reliée mécaniquement au panneau arrière,
- étant maintenue par les éléments (14a, 16a) de guidage dans le porte-modules,
- comportant à sa surface des glissières (21a...21d) perpendiculaires au panneau arrière, dans lesquelles sont maintenus les modules (22a...22c) de hauteur partielle.

2. Dispositif suivant la revendication 1, dans lequel les glissières (21a...21d) comportent des rainures, dans lesquelles pénètrent les barrettes de guidages prévues au bord supérieur et au bord inférieur d'un module (22a...22c).

3. Dispositif suivant la revendication 2, dans lequel les modules sont constitués d'une plaque (23a, 23b) de base dont les bords forment les barrettes de guidage.

4. Dispositif suivant la revendication 3, dans lequel les modules ont du côté opposé au panneau arrière des cadres parallèles au panneau arrière, qui sont de même largeur pour tous les modules de hauteur partielle disposés sur la même plaque de support.

5. Dispositif suivant la revendication 4, dans lequel les modules comprennent un boîtier parallélipipédique, qui est enfilé sur la plaque de base, dont l'une des faces est formée par la plaque de base ou est enfilée sur cette plaque de base et dont la face qui est parallèle à cette face peut être partiellement ou totalement supprimée et dont la face (24a...24c) avant remplace le cadre.

6. Dispositif suivant la revendication 4 ou 5, dans lequel les bords latéraux des cadres sont agrandis par des surfaces perpendiculaires aux cadres, ces surfaces étant, par des ressorts de contact, reliées du point de vue électrique aux plaques de support et aux modules voisins.

7. Dispositif suivant l'une des revendications précédentes, dans lequel la plaque de support comporte une ou plusieurs moulures interrompues, de préférence dans la direction verticale.

8. Dispositif suivant l'une des revendications précédentes, dans lequel un mécanisme pour tirer et pour verrouiller les modules pénètre dans une butée ménagée sur les plaques de support.
